# EUROPÄISCHE PATENTSCHRIFT

(11) **EP 1 020 795 B1**
(45) Veröffentlichungstag und Bekanntmachung des Hinweises auf die Patenterteilung: **14.05.2003**
(21) Anmeldenummer: 00100222.9
(22) Anmeldetag: 14.01.2000
(51) Int. Cl.: G06F 11/20

(54) **Verfahren zur Reparatur von defekten Speicherzellen eines integrierten Halbleiterspeichers**
Method for repairing faulty cells in an integrated semiconductor memory
Procédé de réparation de cellules défaillantes dans une mémoire intégrée à semi-conducteur

(30) Priorität: 14.01.1999 DE 19901206
(43) Veröffentlichungstag der Anmeldung: 19.07.2000
(73) Patentinhaber: Infineon Technologies AG, 81669 München (DE)
(72) Erfinder: Kaiser, Robert, 86916 Kaufering (DE); Schamberger, Florian, 83435 Bad Reichenhall (DE)
(74) Vertreter: Fischer, Volker, Dipl.-Ing.

(56) Entgegenhaltungen:
- EP-A- 0 140 595
- DE-A- 19 736 250
- DAY J R: "A FAULT-DRIVEN, COMPREHENSIVE REDUNDANCY ALGORITHM" IEEE DESIGN & TEST OF COMPUTERS,US,IEEE COMPUTERS SOCIETY. LOS ALAMITOS, Bd. 2, Nr. 3, 1. Juni 1985 (1985-06-01), Seiten 35-44, XP000744056 ISSN: 0740-7475
- LOMBARDI F ET AL: "APPROACHES FOR THE REPAIR OF VLSI/WSI BRAMS BY ROW/COLUMN DELETION" INTERNATIONAL SYMPOSIUM ON FAULT TOLERANT COMPUTING SYSTEMS. (FTCS),US,WASHINGTON, IEEE COMP. SOC. PRESS, Bd. SYMP. 18, 1988, Seiten 342-347, XP000619023

## Beschreibung

Die Erfindung betrifft ein Verfahren zur Reparatur von defekten Speicherzellen eines integrierten Halbleiterspeichers.

In der US 5,410,687 A ist ein derartiges Verfahren beschrieben. Dort werden einzelne Speicherzellen eines Speichers getestet, die sich in Kreuzungspunkten von Zeilen und Spalten befinden. Für jede Spalte und jede Zeile weist der Speicher einen Fehlerzähler auf, in dem die für diese Spalte beziehungsweise Zeile detektierten Fehler aufsummiert werden. Nachdem alle Speicherzellen geprüft worden sind, erfolgt aufgrund der in den Fehlerzählern gespeicherten Informationen eine Reparatur defekter Speicherzellen mittels redundanter Spalten- und Zeilenleitungen. Die zu seiner Durchführung benötigten Fehlerzähler haben einen relativ großen Platzbedarf.

In der US 5,206,583 A ist eine integrierte Schaltung beschrieben, die auftrennbare Verbindungen (Fuses) für eine permanente Programmierung redundanter Elemente aufweist. Die integrierte Schaltung weist weiterhin den Fuses parallel geschaltete reversibel programmierbare Elemente in Form von Latches auf, die zu Testzwecken einer reversiblen Programmierung der redundanten Elemente dienen.

In der internationalen Anmeldung WO-A-00/13087, die zum Stand der Technik gemäß Artikel 54(3) gehört, ist ein Verfahren zur Reparatur von defekten Speicherzellen eines integrierten Halbleiterspeichers beschrieben, die an je eine Zeilenleitung und je eine Spaltenleitung angeschlossen sind. Die Speicherzellen werden nacheinander geprüft, und im Anschluß an das Feststellen eines Defektes der jeweils geprüften Speicherzelle wird die betroffene Zeilenleitung oder die betroffene Spaltenleitung durch Programmierung einer der redundanten Leitungen ersetzt. Nach erfolgter Programmierung einer bestimmten Anzahl der redundanten Leitungen wird bei Feststellen eines weiteren Defekts die Programmierung wenigstens einer der redundanten Leitungen aufgehoben. Diese redundante Leitung wird zur Reparatur eines Defektes einer anderen Speicherzelle programmiert. Dadurch wird eine gewisse Optimierung der durchzuführenden Reparatur erreicht.

Die Aufgabe der Erfindung ist es, ein Verfahren zur Reparatur von defekten Speicherzellen eines integrierten Speichers anzugeben, für das die notwendigen Hardwarekomponenten einen möglichst geringen Flächenbedarf aufweisen.

Die Aufgabe wird gelöst mit einem Verfahren gemäß den Merkmalen des Anspruchs 1. Vorteilhafte Aus- und Weiterbildungen der Erfindung sind in Unteransprüchen gekennzeichnet.

Die Spaltenleitungen können beispielsweise Bitleitungen und die Zeilenleitungen Wortleitungen des integrierten Speichers sein. Bei anderen Ausführungsbeispielen können auch die Spaltenleitungen Wortleitungen und die Zeilenleitungen Bitleitungen des Speichers sein.

Das Verfahren hat den Vorteil, daß keine Fehlerzähler für jede zu prüfende Spaltenleitung und Zeilenleitung notwendig sind, da die Reparatur eines Defektes jeweils nach seiner Feststellung erfolgt. Um eine weitergehende Optimierung der durchzuführenden Reparatur zu erreichen, umfaßt das Verfahren wenigstens zwei unterschiedliche Teilverfahren. Die Teilverfahren werden unterschiedlich ausgeführt und nacheinander aufgerufen, so daß die jeweiligen spezifischen Vorteile der Teilverfahren in der Kombination zu einem verbesserten Ergebnis der durchzuführenden Reparatur beitragen im Vergleich zu Reparaturergebnissen, die durch Einzelaufruf eines einzigen Teilverfahrens zu erzielen wären. Ein verbessertes Reparaturergebnis kann sich beispielsweise dadurch ausdrücken, daß eine möglichst hohe Anzahl an redundanten Leitungen übrig bleibt, die anderweitig noch verwendet werden können, oder daß überhaupt eine Lösung zur Reparatur gefunden wird, die durch ein einzelnes Teilverfahren nicht gefunden werden kann.

Die Teilverfahren unterscheiden sich in der Reihenfolge der Überprüfung der Speicherzellen und darin, welche der redundanten Leitungen zum Ersatz der betroffenen Zeilenleitung oder der betroffenen Spaltenleitung programmiert wird. Außerdem wird eine das jeweilige Teilverfahren abschließende Fehlersignatur ermittelt, die Information über die Anzahl der überprüften Speicherzellen und das Reparaturergebnis enthält. Im Anschluß wird abhängig von der Fehlersignatur des vorangegangenen Teilverfahrens ein anderes Teilverfahren aufgerufen, das zu Beginn die vorgenommene Programmierung nicht, teilweise oder ganz aufhebt. Dadurch ist es möglich, abhängig von dem Reparaturergebnis des vorangegangenen Teilverfahrens ein anderes Teilverfahren auszuwählen, das auf das nunmehr vorliegende Fehlerbild hinsichtlich seiner Reparaturstrategie besser abgestimmt ist und das an die Reparatur des vorangegangenen Teilverfahrens anknüpft oder dieses ganz oder teilweise verwirft.

Die reversible Programmierung der redundanten Leitungen kann beispielsweise mittels reversibel programmierbarer Elemente wie den in der US 5,206,583 A beschriebenen Latches erfolgen. Das erfindungsgemäße Reparaturverfahren zeichnet sich durch einen äußerst geringen Hardwareaufwand aus, so daß es sich besonders zur Implementierung eines Selbsttests und einer Selbstreparatur des zu reparierenden integrierten Speichers eignet. Das bedeutet, das alle erforderlichen Komponenten zur Durchführung des Reparaturverfahrens Bestandteile des integrierten Speichers sind beziehungsweise mit diesem auf derselben integrierten Schaltung angeordnet sind. Andererseits kann das erfindungsgemäße Verfahren selbstverständlich auch softwaremäßig implementiert oder auch durch einen externen Tester des integrierten Speichers durchgeführt werden.

Nach einer Ausführungsform der Teilverfahren wird, wie in der DE 198 38 861.6 beschrieben, nach erfolgter Programmierung einer bestimmten Anzahl der redundanten Leitungen bei Feststellen eines weiteren Defektes die Programmierung wenigstens einer der redundanten Leitungen aufgehoben. Diese redundante Leitung wird zur Reparatur eines Defektes einer anderen Speicherzelle programmiert. Dadurch wird eine gewisse Optimierung der durchzuführenden Reparatur innerhalb eines Teilverfahrens erreicht.

In einer Ausführungsform eines ersten Teilverfahrens werden die Speicherzellen zeilenweise auf Defekte geprüft, und jeweils nach dem Feststellen eines Defektes der gerade geprüften Speicherzelle wird vor dem Überprüfen einer weiteren Speicherzelle die Spaltenleitung, an die die Speicherzelle angeschlossen ist, für die der Defekt festgestellt wurde, durch eine redundante Spaltenleitung ersetzt, sofern die Anzahl der programmierten redundanten Spaltenleitungen dabei einen Grenzwert nicht überschreitet. Bei Überschreiten des Grenzwertes werden alle Programmierungen von redundanten Spaltenleitungen, die auf Grund von in der betroffenen Zeilenleitung festgestellten Defekten erfolgt sind, aufgehoben, und die betroffene Zeilenleitung wird durch eine der redundanten Zeilenleitungen ersetzt.

Bei dieser Ausführungsform erfolgt also eine Reparatur erkannter Defekte jeweils senkrecht zur Testrichtung. Es wird nämlich zeilenweise geprüft und zunächst spaltenweise ersetzt. Erst wenn die Anzahl der bereits verwendeten redundanten Spaltenleitungen den Grenzwert überschreitet, erfolgt eine zumindest teilweise Aufhebung der vorhergehenden Programmierungen. Allerdings werden nur die Programmierungen derjenigen redundanten Spaltenleitungen rückgängig gemacht, die aufgrund von in der betreffenden Zeilenleitung erkannter Defekte programmiert worden sind. Da die betroffene Zeilenleitung anschließend durch eine redundante Zeilenleitung ersetzt wird und die Programmierung von redundanten Spaltenleitungen, die aufgrund von in zuvor geprüften Zeilenleitungen erfolgt sind, nicht aufgehoben werden, werden bei ausreichendem Vorhandensein redundanter Leitungen auf die beschriebene Weise alle festgestellten Defekte innerhalb eines einzigen Prüfdurchlaufs der Speicherzellen repariert.

Nach einer Weiterbildung dieser Ausführungsform des ersten Teilverfahrens wird der Grenzwert für die Anzahl der zu programmierenden redundanten Spaltenleitungen während der Überprüfung verändert. Dies ermöglicht eine Anpassung an die noch vorhandene Anzahl der noch nicht programmierten redundanten Spaltenleitungen.

In einer Ausführungsform eines zweiten Teilverfahrens werden die Speicherzellen, beginnend mit einer Startadresse, geprüft. Nachdem alle redundanten Leitungen programmiert worden sind, wird bei Feststellen eines weiteren Defektes die Programmierung einer der redundanten Leitungen aufgehoben. Die Speicherzellen werden anschließend, beginnend mit der Startadresse, erneut geprüft. Sofern dabei ein Defekt festgestellt wird, der adressenmäßig vor dem weiteren Defekt angeordnet ist, wird die Aufhebung der Programmierung der entsprechenden redundanten Leitung rückgängig gemacht. Das heißt, die entsprechende redundante Leitung wird zum Ersetzen derselben normalen Leitung programmiert, wie vor dem Aufheben ihrer Programmierung. Anschließend werden die drei vorhergehenden Verfahrensschritte bezüglich der Aufhebung der Programmierung einer anderen der redundanten Leitungen wiederholt. Sofern nach der Aufhebung der Programmierung einer der redundanten Leitungen während des daran anschließenden Prüfens der Speicherzellen kein Defekt festgestellt wird, der adressenmäßig vor dem weiteren Defekt angeordnet ist, wird dieser mit der durch die Aufhebung ihrer Programmierung frei gewordenen redundanten Leitung repariert.

Diese Ausführungsform des zweiten Teilverfahrens ermöglicht die Aufhebung der Programmierung derjenigen redundanten Leitungen, die nur bereits festgestellte Defekte reparieren, die außerdem bereits durch andere redundante Leitungen behoben worden sind. Daher bleiben nach Aufhebung der Programmierung der betreffenden redundanten Leitung diese Defekte repariert.

Die Erfindung wird im folgenden anhand der in der Zeichnung dargestellten Figuren näher erläutert.
Es zeigen:
- Figur 1: ein Flußdiagramm einer Ausführungsform des erfindungsgemäßen Reparaturverfahrens,
- Figur 2: ein Flußdiagramm einer Ausführungsform des ersten Teilverfahrens,
- Figur 3: eine Ergänzung des Flußdiagramms aus Figur 2,
- Figur 4: ein Flußdiagramm einer Ausführungsform des zweiten Teilverfahrens,
- Figur 5 bis 11: ein Ausführungsbeispiel für die Durchführung des in Figur 4 dargestellten Teilverfahrens und
- Figuren 12 und 13: ein Ausführungsbeispiel für die Durchführung des in Figur 2 dargestellten Teilverfahrens.

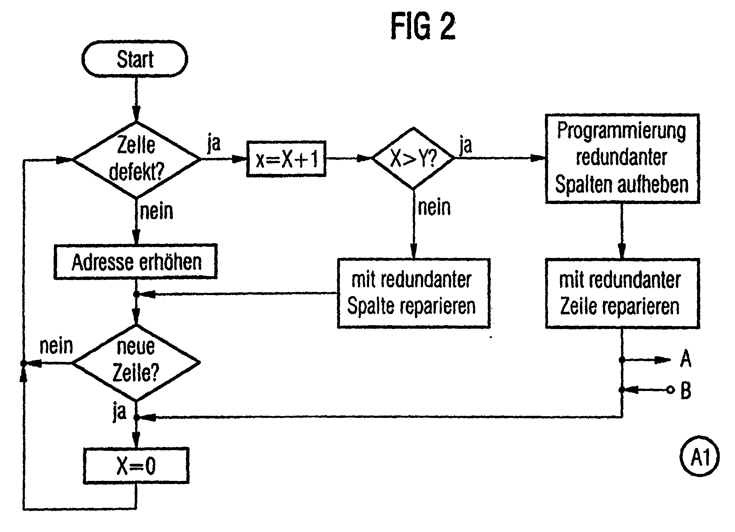

Es werden zunächst die Ausführungsformen der Teilverfahren A1 und A2, wie in der WO-A-00/13087 bereits beschrieben, anhand der Figuren 2 bis 13 erläutert.

Im Teilverfahren A1 werden zunächst in vorangegangenen Teilverfahren vorgenommene Programmierungen von redundanten Leitungen aufgehoben. Gemäß Figur 2 werden die Speicherzellen des integrierten Speichers nacheinander geprüft. Zum Prüfen der jeweils nachfolgenden Speicherzelle wird die Adresse entsprechend erhöht. Jedes Mal zu Beginn des Prüfens einer neuen Zeilenleitung wird ein Zähler X auf Null gesetzt. Wird ein Defekt erkannt, wird der Zähler X um Eins erhöht und es erfolgt ein Vergleich des Standes des Zählers X mit einem Grenzwert Y. Der Grenzwert Y gilt für die Anzahl der maximal zugelassenen, für die Reparatur in der aktuellen Zeilenleitung programmierten Spaltenleitungen. Das Prüfen der Speicherzellen erfolgt nämlich zeilenweise, während bei Feststellen eines Defektes die Reparatur spaltenweise durchgeführt wird. Solange bei Feststellen eines Defekts der Zähler X den Grenzwert Y nicht überschreitet, wird der Defekt durch eine redundante Spaltenleitung behoben. Überschreitet der Zähler X jedoch den Grenzwert Y, wird die Programmierung derjenigen redundanten Spaltenleitungen aufgehoben, die zur Reparatur von in der aktuellen Zeilenleitung erkannten Defekten programmiert worden sind. Anschließend wird die aktuelle Zeilenleitung durch eine redundante Zeilenleitung repariert.

Besonders günstig ist es, wenn die ersetzende redundante Zeilenleitung nach dem Ersetzen selbst auf Fehler überprüft wird. Zu diesem Zweck wird das erste Teilverfahren mit der Überprüfung derjenigen Speicherzelle der redundanten Zeilenleitung fortgesetzt, die die niedrigste Spaltenadresse hat. Werden Fehler auf der redundanten Zeilenleitung entdeckt, erfolgt, wie zuvor, zunächst eine Reparatur über die redundanten Spaltenleitungen. Überschreitet deren Anzahl den zulässigen Grenzwert, wird ihre Programmierung aufgehoben und die redundante Zeilenleitung durch eine andere redundante Zeilenleitung ersetzt. Die Überprüfung der Speicherzellen einer programmierten redundanten Zeilenleitung kann selbstverständlich entfallen, wenn die redundanten Leitungen vor ihrer Programmierung geprüft worden sind und anschließend nur fehlerfreie redundante Leitungen für eine Reparatur herangezogen werden.

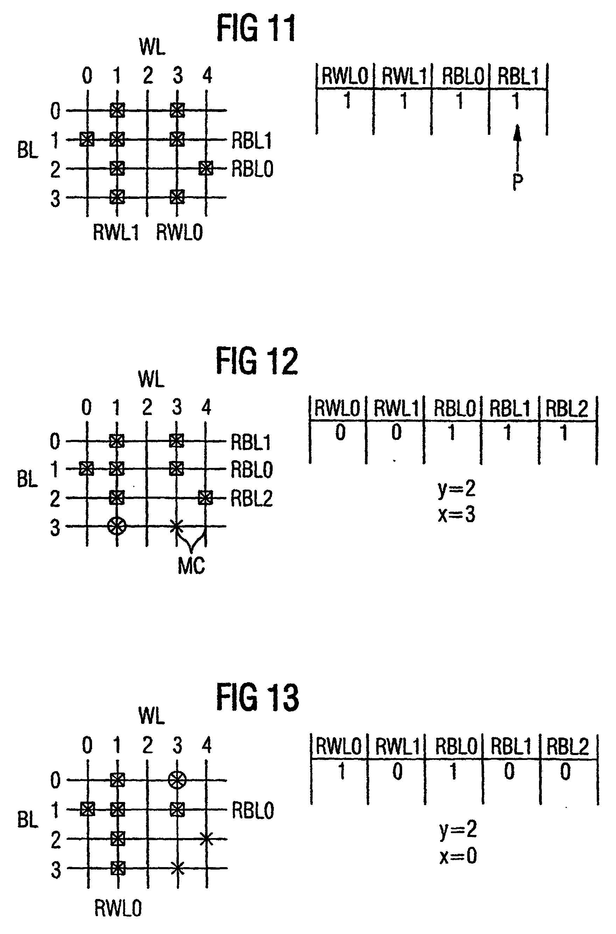

Ein Ausführungsbeispiel der Ausführungsform des ersten Teilverfahrens A1 soll im folgenden anhand der Figuren 12 und 13 beschrieben werden. In Figur 12 ist im linken Teil ein Speicherzellenfeld des integrierten Speichers und im rechten Teil eine Übersicht über die redundanten Leitungen dargestellt. Die Figuren 12 und 13 sowie 5 bis 11 verwenden im wesentlichen dieselbe Darstellungsweise, weshalb auf diese nur einmal eingegangen wird. Die Speicherzellen MC des integrierten Speichers sind in Kreuzungspunkten von Bitleitungen BL und Wortleitungen WL angeordnet. Die Bitleitungen BL sind von 0 bis 3 und die Wortleitungen WL von 0 bis 4 durchnumeriert. Defekte Speicherzellen MC sind durch Kreuze markiert. Bereits durch redundante Leitungen reparierte Speicherzellen MC sind durch Quadrate markiert. Ein Kreis markiert den aktuellen, also soeben erst festgestellten Defekt einer der Speicherzellen MC. Im rechten Teil der Figur 12 ist eine Tabelle dargestellt, die zur Veranschaulichung alle zur Verfügung stehenden redundanten Leitungen des Speichers enthält. Beim anhand der Figuren 12 und 13 erläuterten Ausführungsbeispiel weist der Speicher zwei redundante Wortleitungen RWL0, RWL1 und drei redundante Bitleitungen RBL0, RBL1, RBL2 auf. Die Tabelle gibt an, welche dieser redundanten Leitungen bereits zum Ersetzen einer der normalen Leitungen BL, WL programmiert worden ist. Eine Null bedeutet dabei, das die zugehörige redundante Leitung noch nicht programmiert worden ist, und eine Eins bedeutet, daß bereits eine Programmierung erfolgt ist.

Dem linken Teil der Figur 12 ist auch zu entnehmen, auf welche Weise die defekten Speicherzellen MC repariert worden sind. Rechts des Speicherzellenfeldes sind nämlich die zum Ersetzen der jeweiligen normalen Bitleitungen BL programmierten redundanten Bitleitungen RBLi eingetragen und unterhalb des Speicherzellenfeldes die zum Ersetzen der normalen Wortleitungen programmierten redundanten Wortleitungen RWLi. Im vorliegenden Fall erfolgte bereits vor dem in Figur 12 dargestellten Zustand ein sequentielles Prüfen der Speicherzellen MC, beginnend mit der Speicherzellenadresse 0,0 (das heißt Wortleitung WL0 und Bitleitung BL0), und zwar in Richtung der Wortleitungen WL. Die Speicherzelle 0,0 weist keinen Defekt auf. Anschließend wurde die Speicherzelle 0,1 geprüft (Wortleitung WL0, Bitleitung BL1), wobei ein Defekt festgestellt wurde. Dieser Defekt wurde dadurch repariert, daß die Bitleitung 1 durch die redundante Bitleitung RBL0 ersetzt wurde.

Anschließend wurden die Speicherzellen weiter getestet, wobei beim Beginn der nächsten Wortleitung WL1 der Fehlerzähler X auf 0 rückgesetzt wurde. Die defekte Speicherzelle 1,0 auf der Wortleitung WL1 wurde durch die redundante Bitleitung RBL1 repariert und der Fehlerzähler X auf den Wert 1 erhöht. Da die Bitleitung BL1 bereits durch die redundante Bitleitung RBL0 ersetzt worden ist, ist der nächste festgestellte Fehler derjenige mit der Adresse 1,2. Dieser wird mit der redundanten Bitleitung RBL2 repariert. Der Fehlerzähler X wird auf 2 erhöht. Als nächstes wird der Defekt der Speicherzelle 1,3 festgestellt. Dieser Zustand ist in Figur 12 dargestellt. Dieser Defekt wird nicht mit einer redundanten Bitleitung repariert, da der Behlerzähler X auf Drei erhöht wird und damit den Grenzwert Y, der ebenfalls den Wert Zwei hat, überschritten hat. Als Folge dessen wird die Programmierung der redundanten Bitleitungen RBL1 und RBL2, die aufgrund der in der aktuellen Wortleitung WL1 festgestellten Defekte an den Adressen 1,0 und 1,2 festgestellt worden sind, aufgehoben. Die Programmierung der redundanten Bitleitung RBL0, die die normale Bitleitung BL1 ersetzt, wird dagegen nicht aufgehoben, da sie nicht aufgrund eines in der aktuellen Wortleitung WL1 detektierten Defektes erfolgte. Ihre Programmierung erfolgte aufgrund des in der Wortleitung WL0 festgestellten Defektes mit der Adresse 0,1. Anschließend wird die normale Wortleitung WL1 durch die redundante Wortleitung RWL0 ersetzt.

Figur 13 zeigt diesen Zustand des integrierten Speichers. Der Grenzwert Y wird wiederum auf den Wert 2 festgesetzt, da erneut zwei der redundanten Bitleitungen RBLi für eine Programmierung zur Verfügung stehen. Dies sind die redundanten Bitleitungen RBL1 und RBL2, deren Programmierung, wie soeben beschrieben, aufgehoben worden ist. Die Speicherzellen werden fortlaufend geprüft, so daß als nächstes der Defekt mit der Adresse 3,0 festgestellt wird. Dieser wird wiederum mit einer der redundanten Bitleitungen RBLi repariert. Das erste Teilverfahren wird auf analoge Weise fortgesetzt, wobei die Programmierung einiger der redundanten Bitleitungen immer dann aufgehoben wird, wenn der Stand des Zählers X den Grenzwert Y überschreitet.

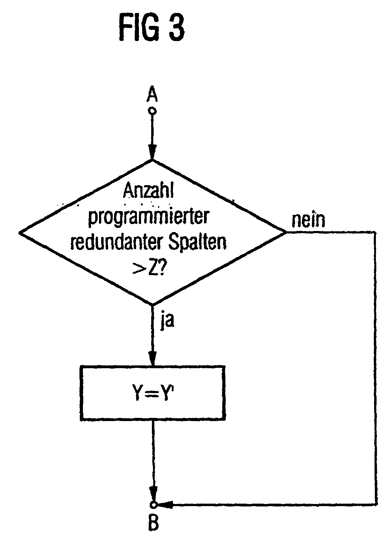

Ändert sich die Zahl der zur Verfügung stehenden, noch nicht programmierten redundanten Bitleitungen RBLi, wird zu Beginn des Prüfens der nächsten Wortleitung WLi der Grenzwert Y neu festgesetzt. Figur 3 ist eine Ergänzung des Flußdiagramms aus Figur 2 an der mit A und B bezeichneten Stelle zu entnehmen, wonach der Grenzwert Y beispielsweise dann angepaßt wird, wenn die Anzahl der bereits programmierten redundanten Spaltenleitungen einen Wert Z überschreitet. In diesem Fall steht nur noch eine relativ geringe Anzahl von redundanten Spaltenleitungen für eine Programmierung zur Verfügung, so daß der Grenzwert Y auf einen Wert Y' erniedrigt werden muß.

Das erste Teilverfahren A1 wird beendet, wenn alle defekten Speicherzellen MC repariert sind oder wenn nach Feststellen eines weiteren Defektes bei Überschreiten des Grenzwertes Y alle redundanten Zeilenleitungen RWL bereits programmiert sind.

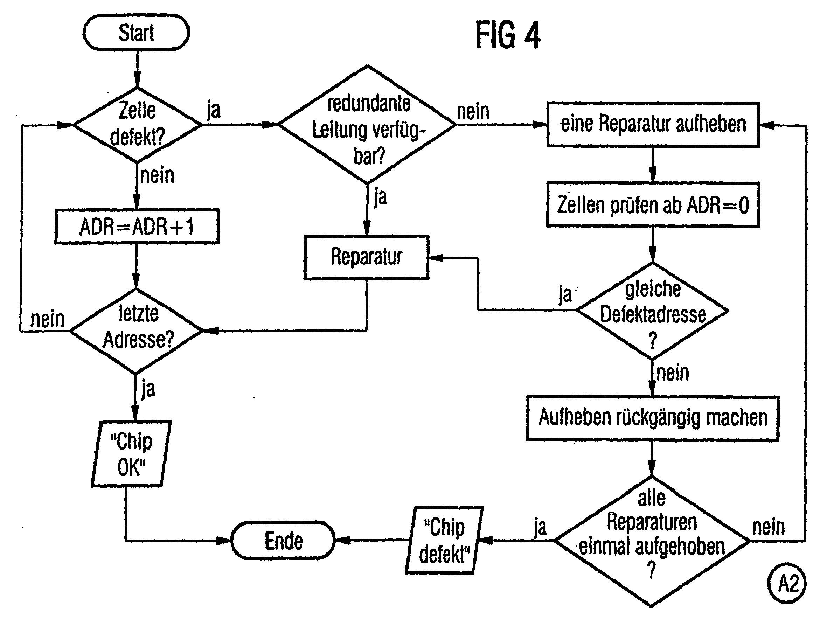

Figur 4 zeigt das Flußdiagramm für eine Ausführungsform des zweiten Teilverfahrens A2. Die Speicherzellen werden, beginnend mit einer Adresse ADR sequentiell geprüft. So lange kein Fehler festgestellt wird, wird die Adresse fortlaufend inkrementiert. Wenn die letzte Adresse erreicht worden ist und kein Defekt als nicht reparierbar übrig bleibt, gilt die integrierte Schaltung als repariert und das Reparaturverfahren wird beendet. Sobald eine defekte Speicherzelle festgestellt worden ist, erfolgt, solange noch eine redundante Leitung für eine Programmierung zur Verfügung steht, eine Reparatur des Defekts durch Ersetzen der betroffenen Zeilenleitung oder der betroffenen Spaltenleitung durch eine entsprechende redundante Leitung. Sind jedoch bereits alle redundanten Leitungen programmiert worden, wird die Programmierung einer der redundanten Leitungen aufgehoben, so daß wieder die ursprüngliche, normale Spalten- beziehungsweise Zeilenleitung adressiert wird. Anschließend werden alle Speicherzellen, beginnend mit der Startadresse ADR, erneut sequentiell geprüft. Wird dabei kein Defekt festgestellt, der adressenmäßig vor dem zuletzt festgestellten Defekt liegt, steht fest, daß die durch die redundante Leitung, deren Programmierung aufgehoben worden ist, reparierten Defekte auch durch andere redundante Leitungen (also mehrfach) repariert worden sind. Daher kann die freigewordene redundante Leitung zur Reparatur des zuletzt festgestellten Defektes verwendet werden. Wird jedoch ein Defekt mit niedriger Adresse festgestellt, als diejenige des zuletzt festgestellten Defektes, wird die Aufhebung der Programmierung der betroffenen redundanten Leitung rückgängig gemacht. Das bedeutet, sie wird genauso erneut programmiert, wie es vor dem Aufheben ihrer Programmierung der Fall war. Diese redundante Leitung kann also nicht für eine Reparatur des aktuellen Defektes verwendet werden. Statt dessen wird die Programmierung einer anderen der redundanten Leitungen aufgehoben und die Zellen werden erneut geprüft. Dieses Verfahren wird solange wiederholt, bis die Aufhebung der Programmierung einer der redundanten Leitung zum Erfolg führt oder bis die Programmierung aller redundanten Leitungen nacheinander aufgehoben worden ist, ohne das der aktuelle Defekt repariert werden konnte. Im letztgenannten Fall wird der Chip als defekt gekennzeichnet und das zweite Teilverfahren A2 beendet.

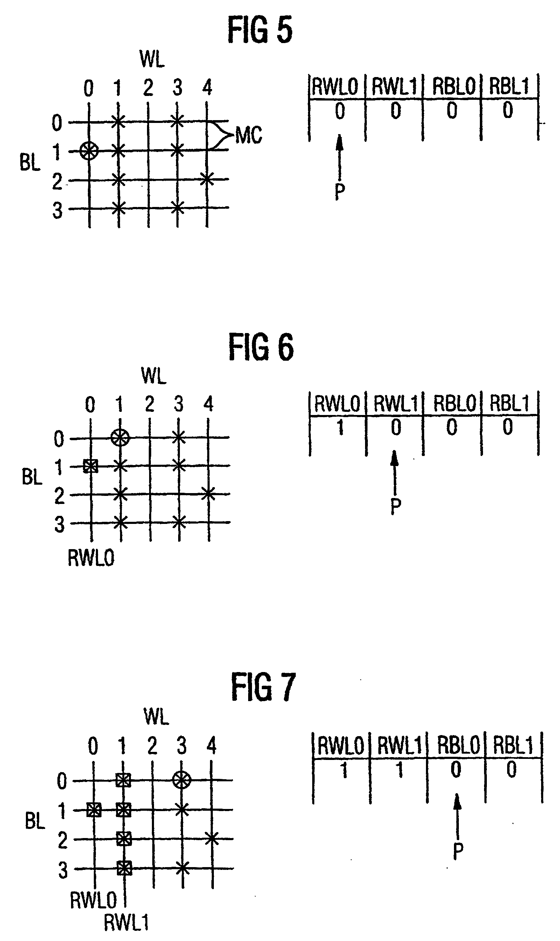

Im folgenden wird anhand der Figuren 5 bis 11 ein konkretes Ausführungsbeispiel des in Figur 4 dargestellten zweiten Teilverfahrens A2 geschildert. Bei diesem Ausführungsbeispiel verfügt der integrierte Speicher über zwei redundante Wortleitungen RWL0, RWL1 und zwei redundante Bitleitungen RBL0, RBL1. Defekte Speicherzellen MC sind wiederum durch Kreuze im Speicherzellenfeld gekennzeichnet. Der Kreis kennzeichnet den aktuellen festgestellten Defekt. Die Reparatur erkannter Defekte erfolgt bei diesem Ausführungsbeispiel durch Programmierung der redundanten Leitungen in der in der Tabelle im rechten Teil der Figuren dargestellten Reihenfolge. Zur Reparatur des ersten Defektes mit Adresse 0,1 (Wortleitung WL0, Bitleitung BL1) wird daher die redundante Wortleitung RWL0 verwendet. Ein Zeiger P zeigt auf die jeweils als nächstes zu verwendende redundante Leitung.

Figur 6 zeigt den integrierten Speicher, nachdem die Wortleitung WL0 adressenmäßig durch die redundante Wortleitung RBL0 ersetzt worden ist. Die erfolgte Programmierung der redundanten Wortleitung RWL0 ist in der Tabelle durch eine 1 gekennzeichnet. Der Zeiger P zeigt auf die als nächstes zu programmierende redundante Leitung RWL1. Das Prüfen der Speicherzellen wird sequentiell fortgesetzt und als nächstes der Defekt der Speicherzelle 1,0 festgestellt. Gemäß Figur 7 wird dieser Defekt durch Programmierung der redundanten Wortleitung RWL1 repariert. Automatisch werden dabei auch die anderen Defekte auf der Wortleitung WL1 repariert, ohne daß diese geprüft werden müssen. Hierbei wird vorausgesetzt, daß die programmierten redundanten Leitungen jeweils fehlerfrei sind. Dies kann durch einen vor ihrer Programmierung durchgeführten Test festgestellt werden. Es werden nur die dabei als fehlerfrei festgestellten redundanten Leitungen für eine Reparatur herangezogen.

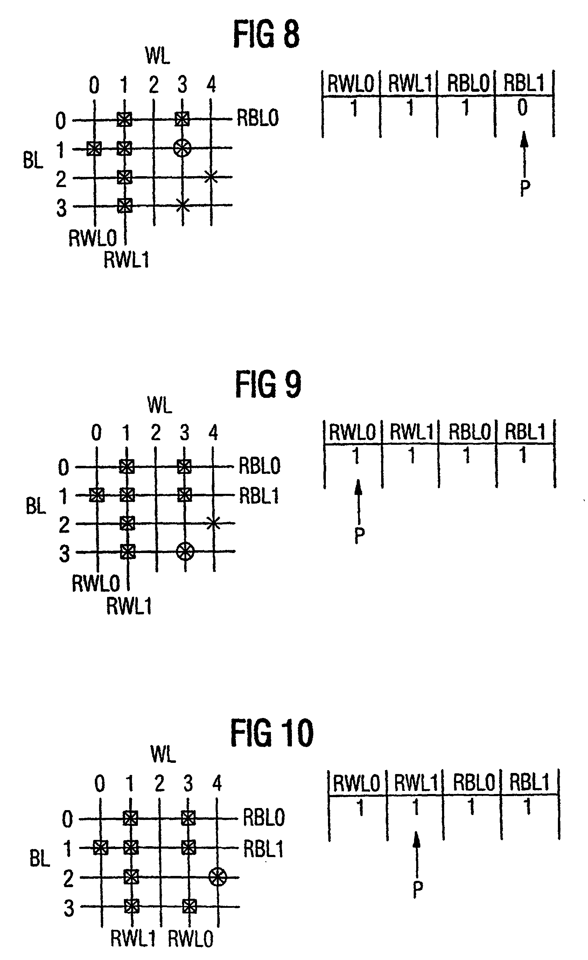

Da die nächste Wortleitung WL2 keinen Defekt aufweist, ist der nächste festgestellte Defekt derjenige mit der Adresse 3,0. Der Zeiger P zeigt inzwischen auf die dritte redundante Leitung RBL0, so daß der aktuelle Defekt durch die redundante Bitleitung RBL0 ersetzt wird. Dies ist in Figur 8 dargestellt. Gemäß Figur 9 wird der nächste Defekt mit der Adresse 3,1 durch die redundante Bitleitung RBL1 ersetzt.

Der nächste festgestellte Defekt mit der Adresse 3,3 kann nun nicht mehr ohne weiteres repariert werden, da bereits alle redundanten Leitungen programmiert worden sind und der Zeiger P erneut auf die erste redundante Leitung RWL0 zeigt. Bei diesem Ausführungsbeispiel wird nun die Programmierung derjenigen redundanten Leitung, auf die der Zeiger P zeigt (dies ist die als erste programmierte redundante Leitung RWL0), aufgehoben. Da der einzige bislang durch die redundante Wortleitung RWL0 reparierte Defekt derjenige mit der Adresse 0,1 ist, und dieser Defekt außerdem auch durch die Programmierung der redundanten Bitleitung RBL1 behoben worden ist, wird beim anschließenden Test aller Speicherzellen kein Defekt festgestellt, der adressenmäßig vor dem aktuellen Defekt mit der Adresse 3,3 angeordnet ist. Daher wird die durch die Aufhebung ihrer Programmierung frei gewordene redundante Wortleitung RWL0 zur Reparatur des Defekts der Speicherzelle 3,3 verwendet. Dieser Zustand ist in Figur 10 dargestellt. Der Zeiger P rückt zur nächsten redundanten Leitung vor. Der Speichertest wird mit den noch nicht geprüften Speicherzellen MC fortgesetzt und es wird der Defekt mit Adresse 4,2 festgestellt. Anschließend wird die Programmierung der redundanten Wortleitung RWL1, auf die der Zeiger P zeigt, rückgängig gemacht. Die Speicherzellen werden, beginnend mit der Adresse 0,0 erneut geprüft, wobei der Defekt mit der Adresse 1,2 als erstes festgestellt wird. Dessen Adresse ist kleiner als die Adresse 4,2 des aktuellen Defekts. Daher wird die Aufhebung der Programmierung der redundanten Wortleitung RWL1 wieder rückgängig gemacht.

Der Zeiger rückt auf die nächste redundante Leitung RBL0 vor (Figur 11). Da der aktuelle Defekt mit der Adresse 4,2 noch immer nicht repariert ist, wird nun die Programmierung dieser redundanten Leitung RBL0 aufgehoben. Die Speicherzellen werden, beginnend mit der Startadresse 0,0 erneut getestet. Dabei wird kein Defekt festgestellt, der vor dem aktuellen Defekt mit der Adresse 4,2 liegt. Dies liegt daran, daß die Defekte mit den Adressen 1,0 und 3,0 bereits durch die redundanten Wortleitungen RBL1 und RWL0 repariert worden sind. Somit kann die frei gewordene redundante Bitleitung RBL0 zur Reparatur des aktuellen Defektes programmiert werden. Dieser Zustand ist in Figur 11 gezeigt. Der Zeiger P rückt auf die nächste programmierte redundante Leitung RBL1 vor. Als letztes wird noch die Speicherzelle mit der Adresse 4,3 geprüft, die keinen Defekt aufweist. Daher wird das Reparaturverfahren mit einem vollständig reparierten integrierten Speicher abgeschlossen.

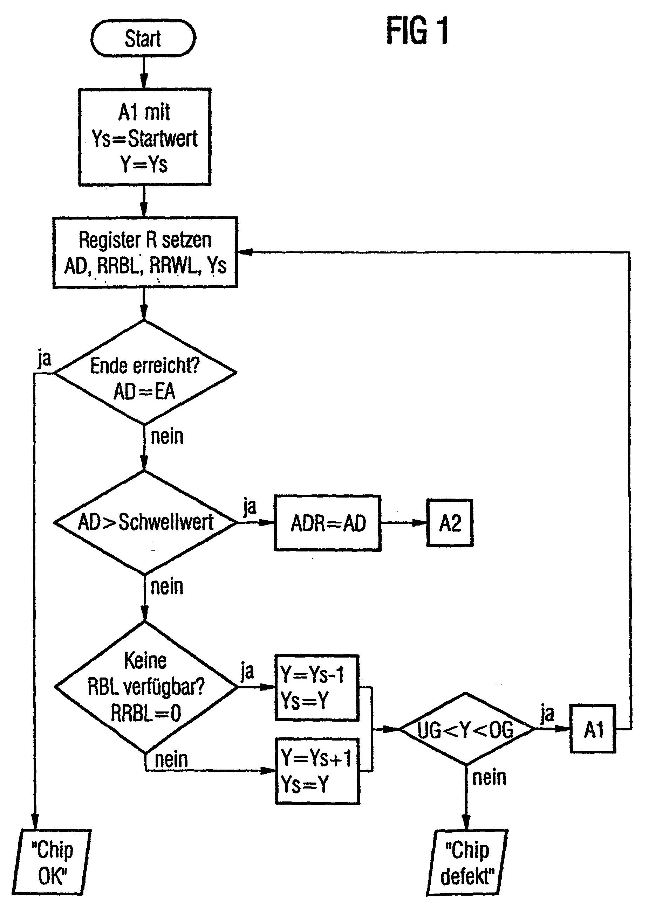

Figur 1 zeigt ein Flußdiagramm einer Ausführungsform des erfindungsgemäßen Reparaturverfahrens. Dieses beginnt mit Aufruf des ersten Teilverfahrens A1, wobei ein Startwert YS für den Grenzwert Y festgesetzt wird. Das erste Teilverfahren A1 endet, wie beschrieben, wenn alle defekten Speicherzellen MC repariert sind oder wenn nach Feststellen eines weiteren Defekts bei Überschreiten des Grenzwertes Y alle redundanten Zeilenleitungen bereits programmiert sind. Das bedeutet, ein Aufheben aller Programmierungen von redundanten Spaltenleitungen RBL, die aufgrund von in der betroffenen Zeilenleitung WL festgestellten Defekten erfolgt sind, kann nicht erfolgen, da die betroffene Zeilenleitung WL nicht durch eine der redundanten Zeilenleitungen RWL ersetzt werden kann.

Am Ende des ersten Teilverfahrens A1 wird eine Fehlersignatur R in Form eines Registers erstellt. Dieses enthält Information über die Anzahl der überprüften Speicherzellen MC und das Reparaturergebnis. Die Anzahl der überprüften Speicherzellen MC kann beispielsweise anhand der Adresse der zuletzt überprüften Speicherzelle MC oder über die Adresse der als nächstes zu überprüfenden Speicherzelle MC ermittelt werden. Das Reparaturergebnis drückt sich in der Anzahl der programmierten redundanten Leitungen RBL, RWL oder der Anzahl der verbleibenden redundanten Leitungen RBL, RWL, hier als RRBL, RRWL bezeichnet, aus.

Anhand der Adresse AD der zuletzt überprüften Speicherzelle MC wird das weitere Vorgehen ermittelt. Entspricht diese der letzten zu überprüfenden Adresse EA des Speichers, sind alle defekten Speicherzellen MC repariert und das Verfahren wird beendet. Im anderen Fall wird geprüft, ob die Adresse AD der zuletzt überprüften Speicherzelle MC einen Schwellwert überschreitet. In diesem Fall wird das zweite Teilverfahren A2 aufgerufen, wobei der Startwert der Adresse ADR den Wert der Adresse AD der zuletzt überprüften Speicherzelle MC erhält. D. h. das zweite Teilverfahren A2 beginnt mit der zuletzt geprüften Speicherzelle MC, es hebt zu Beginn die Programmierungen des vorherigen Teilverfahrens A1 also nicht auf. Das Verfahren endet in jedem Falle nach Beendigung des zweiten Teilverfahrens A2. Konnten nicht alle Speicherzellen MC repariert werden, wird der Speicher als defekt gekennzeichnet.

Bleibt die Adresse AD der zuletzt überprüften Speicherzelle MC unter dem Schwellwert, wird der Grenzwert Y für einen folgenden Aufruf des ersten Teilverfahrens A1 ausgehend vom aktuellen Wert YS um 1 erniedrigt oder erhöht, abhängig davon, ob keine redundante Bitleitung RBL mehr verfügbar ist (RRBL = O) oder nicht. Anschließend wird wieder das erste Teilverfahren A1 aufgerufen mit dem Setzen einer neuen Fehlersignatur R nach dessen Beendigung und einem erneuten Aufruf eines anderen Teilverfahrens und so weiter, wie oben beschrieben. Allerdings muß vor Aufruf des ersten Teilverfahrens A1 eine Abbruchbedingung durchlaufen werden, die das Verfahren beendet, wenn der Grenzwert Y nicht innerhalb eines vorgegebenen Wertebereichs ist (UG = Untergrenze, OG = Obergrenze). In diesem Fall wird der Speicher als defekt gekennzeichnet und das Verfahren beendet.

Das Verfahren wird also solange mit dem Aufruf eines der Teilverfahren A1, A2 fortgesetzt, bis alle Speicherzellen MC überprüft und repariert sind oder der Speicher als nicht reparierbar gekennzeichnet ist.

Die Information der Fehlersignatur R wird anhand ein oder mehrerer Parameter zwischengespeichert. Diese sind während der Laufzeit des Verfahrens veränderbar. Als Parameter werden hier die Adresse AD der zuletzt überprüften Speicherzelle MC, die Anzahl der verbliebenen redundanten Leitungen RRBL, RRWL und der jeweilige Wert YS als Ausgangswert für den Grenzwert Y für ein folgendes erstes Teilverfahren A1 verwendet.

Wie bereits beschrieben besteht der Vorteil des Verfahrens in der Kombination mehrerer unterschiedlicher Teilverfahren, die ihrerseits jeweilige spezifische Stärken in der Erkennung eines speziellen Fehlerbildes zeigen. Bei Anwendung des ersten Teilverfahrens A1 kann beispielsweise der Grenzwert Y zu Anfang des Verfahrens stärker variiert werden (wird an der entsprechenden Stelle um mehr als 1 erhöht oder erniedrigt) und zu Ende des Verfahrens weniger stark. So "tastet" man sich schrittweise zu einer genügend guten Lösung vor (mathematisch ausgedrückt, man kommt bei der Lösungssuche an ein "globales Minimum" und endet nicht in einem "lokalen Minimum"). Mit dem zweiten Teilverfahren werden bei entsprechendem Reparaturfortschritt etwaige Doppelreparaturen aufgehoben.

Ein weiterer Vorteil des Verfahrens gegenüber einem Verfahren, das aus der Gesamtheit der Defekte eine Lösungsmöglichkeit zur Reparatur berechnet, besteht darin, daß das erfindungsgemäße Verfahren beendet wird, sobald eine Lösung gefunden wird. D. h., es wird nur eine genügend gute Lösung gesucht und nicht die beste, wodurch die Rechenzeit optimiert wird.

Es können außer oder statt den beschriebenen Teilverfahren A1 und A2 auch andere oder weitere Teilverfahren eingesetzt werden, die hinsichtlich ihrer Reparaturstrategie unterschiedlich zu den beschriebenen Teilverfahren A1 und A2 ausgeführt sind. Die Stärken solcher Teilverfahren können in der Lösungssuche zu anderen Fehlerbildern liegen. Um die Vorteile der jeweiligen Teilverfahren besser zu nutzen ist es günstig, die Parameter der Fehlersignaturen R an das jeweils folgende Teilverfahren zu übergeben. Damit kann an das vorhergehende Reparaturergebnis angeknüpft werden. Je nach Parameterwerten der jeweiligen Fehlersignatur R wird zu Beginn des folgenden Teilverfahrens das vorhergehende Reparaturergebnis nicht, ganz oder auch teilweise verworfen. Darüber hinaus ist es je nach Art und Ausführung der verwendeten Teilverfahren notwendig, die Fehlersignatur hinsichtlich ihrer verwendeten Parameter entsprechend anzupassen.

## Patentansprüche

1. Verfahren zur Reparatur von defekten Speicherzellen (MC) eines integrierten Halbleiterspeichers, die an je eine Zeilenleitung (WL) und je eine Spaltenleitung (BL) angeschlossen sind, durch eine reversible Programmierung von redundanten Zeilenleitungen (RWL) und redundanten Spaltenleitungen (RBL) mit folgenden Merkmalen:
- es werden wenigstens zwei unterschiedliche Teilverfahren (A1, A2) zur Reparatur von defekten Speicherzellen (MC) verwendet, die nacheinander ablaufen,
- in den Teilverfahren (A1, A2) werden die Speicherzellen (MC) nacheinander geprüft, und jeweils nach dem Feststellen eines Defektes der jeweils geprüften Speicherzelle wird vor dem Überprüfen einer weiteren Speicherzelle die Zeilenleitung (WL) oder die Spaltenleitung (BL), an die die Speicherzelle angeschlossen ist, für die der Defekt festgestellt wurde, durch Programmierung einer der redundanten Leitungen (RWL, RBL) ersetzt,
- die Teilverfahren (A1, A2) unterscheiden sich in der Reihenfolge der Überprüfung der Speicherzellen (MC) und darin, welche der redundanten Leitungen (RWL, RBL) zum Ersatz der betroffenen Zeilenleitung (WL) oder der betroffenen Spaltenleitung (BL) programmiert wird,
- es wird ein Teilverfahren (A1, A2) mit einer das Teilverfahren abschließenden Fehlersignatur (R) aufgerufen, die Information über die Anzahl der überprüften Speicherzellen (MC) und die Anzahl der programmierten redundanten Leitungen (RBL, RWL) oder verbleibenden redundanten Leitungen (RRBL, RRWL) enthält,
- im Anschluß wird abhängig von der Fehlersignatur (R) des vorangegangenen Teilverfahrens (A1, A2) ein anderes der Teilverfahren (A1, A2) aufgerufen, das zu Beginn die vorgenommene Programmierung nicht, teilweise oder ganz aufhebt.

2. Verfahren nach Anspruch 1,
**dadurch gekennzeichnet, daß** das Verfahren solange mit dem Aufruf eines der Teilverfahren (A1, A2) fortgesetzt wird, bis alle Speicherzellen (MC) überprüft und repariert sind oder der Speicher als nicht reparierbar gekennzeichnet ist.

3. Verfahren nach einem der vorhergehenden Ansprüche,
**dadurch gekennzeichnet, daß** die Fehlersignatur (R) ein oder mehrere Parameter (AD, RRWL, RRBL, YS) umfaßt, die während der Laufzeit in ihren Werten veränderbar sind.

4. Verfahren nach Anspruch 3,
**dadurch gekennzeichnet, daß** die Werte der veränderbaren Parameter (AD, RRWL, RRBL, YS) jeweils an das dem gerade aktiven Teilverfahren (A1, A2) folgende Teilverfahren (A1, A2) übergeben werden.

5. Verfahren nach einem der vorhergehenden Ansprüche,
**dadurch gekennzeichnet, daß** die Teilverfahren (A1, A2) folgende Schritte umfassen:
- nach erfolgter Programmierung einer bestimmten Anzahl der redundanten Leitungen (RWL, RBL) wird bei Feststellen eines weiteren Defektes die Programmierung wenigstens einer der redundanten Leitungen aufgehoben,
- und diese redundante Leitung (RWL, RBL) wird zur Reparatur eines Defektes einer anderen Speicherzelle (MC) programmiert.

6. Verfahren nach Anspruch 5,
**dadurch gekennzeichnet, daß** ein erstes Teilverfahren (A1) folgende Schritte umfaßt:
- in vorangegangenen Teilverfahren (A1, A2) vorgenommene Programmierungen von redundanten Leitungen (RWL, RBL) werden aufgehoben,
- die Speicherzellen (MC) werden, beginnend mit einer Startadresse, zeilenweise auf Defekte geprüft,
- bei Feststellen eines Defektes der gerade geprüften Speicherzelle (MC) wird die betroffene Spaltenleitung (BL) durch eine der redundanten Spaltenleitungen (RBL) ersetzt, sofern die Anzahl (X) der programmierten redundanten Spaltenleitungen RBL dabei einen Grenzwert (Y) nicht überschreitet,
- bei Überschreiten des Grenzwertes (Y) werden alle Programmierungen von redundanten Spaltenleitungen (RBL), die aufgrund von in der betroffenen Zeilenleitung (WL) festgestellten Defekten erfolgt sind, aufgehoben,
- und die betroffene Zeilenleitung (WL) wird durch eine der redundanten Zeilenleitungen (RWL) ersetzt.

7. Verfahren nach Anspruch 6,
**dadurch gekennzeichnet, daß** das erste Teilverfahren (A1) beendet wird, wenn alle Speicherzellen (MC) repariert sind oder wenn nach Feststellen des weiteren Defektes bei Überschreiten des Grenzwertes (Y) alle redundanten Zeilenleitungen (RWL) bereits programmiert sind.

8. Verfahren nach Anspruch 6,
**dadurch gekennzeichnet, daß** der Grenzwert (Y) während der Laufzeit des ersten Teilverfahrens (A1) verändert wird.

9. Verfahren nach Anspruch 5,
**dadurch gekennzeichnet, daß** ein zweites Teilverfahren (A2) folgende Schritte umfaßt:
- die Speicherzellen (MC) werden, beginnend mit einer Startadresse, geprüft,
- nachdem alle redundanten Leitungen (RWL, RBL) programmiert worden sind, wird bei Feststellen eines weiteren Defektes die Programmierung einer der redundanten Leitungen aufgehoben,
- die Speicherzellen (MC) werden anschließend, beginnend mit der Startadresse, erneut geprüft,
- sofern dabei ein Defekt festgestellt wird, der adressenmäßig vor dem weiteren Defekt angeordnet ist, wird die Aufhebung der Programmierung der entsprechenden redundanten Leitung (RWL, RBL) rückgängig gemacht,
- anschließend werden die drei vorhergehenden Verfahrensschritte bezüglich der Aufhebung der Programmierung einer anderen der redundanten Leitungen (RWL, RBL) wiederholt,
- sofern nach der Aufhebung der Programmierung einer der redundanten Leitungen (RWL, RBL) während des daran anschließenden Prüfens der Speicherzellen (MC) kein Defekt festgestellt wird, der adressenmäßig vor dem weiteren Defekt angeordnet ist, wird dieser mit der durch die Aufhebung ihrer Programmierung frei gewordenen redundanten Leitung repariert.

10. Verfahren nach Anspruch 9,
**dadurch gekennzeichnet, daß** das zweite Teilverfahren (A2) beendet wird, wenn alle Speicherzellen (MC) repariert sind oder wenn nach Feststellen des weiteren Defektes die nacheinander durchgeführte Aufhebung der Programmierung aller redundanten Leitungen (RBL, RWL) keine Reparatur aller bislang erkannten Defekte ermöglicht.

## Claims

1. Method for repairing defective memory cells (MC) of an integrated semiconductor memory, which are connected to a respective row line (WL) and a respective column line (BL), by reversible programming of redundant row lines (RWL) and redundant column lines (RBL), having the following features:
- use is made of at least two different submethods (A1, A2) for repairing defective memory cells (MC), which proceed one after the other,
- in the submethods (A1, A2), the memory cells (MC) are successively tested, and, in each case after a defect of the respectively tested memory cell has been ascertained, before a further memory cell is checked, the row line (WL) or the column line (BL) to which the memory cell for which the defect was ascertained is connected is replaced by programming one of the redundant lines (RWL, RBL),
- the submethods (A1, A2) differ in terms of the order in which the memory cells (MC) are checked, and in terms of which of the redundant lines (RWL, RBL) is programmed for the purpose of replacing the relevant row line (WL) or the relevant column line (B1),
- one submethod (A1, A2) is called with a defect signature (R) which terminates the submethod and contains information about the number of checked memory cells (MC) and the number of programmed redundant lines (RBL, RWL) or remaining redundant lines (RRBL, RRWL),
- subsequently, depending on the defect signature (R) of the preceding submethod (A1, A2), another of the submethods (A1, A2) is called, which initially does not cancel, partially cancels, or entirely cancels, the programming that has been performed.

2. Method according to Claim 1,
**characterized in that** the method is continued with the calling of one of the submethods (A1, A2) until all of the memory cells (MC) have been checked and repaired or the memory is identified as irreparable.

3. Method according to one of the preceding claims,
**characterized in that** the defect signature (R) comprises one or more parameters (AD, RRWL, RRBL, YS) whose values can be varied during the execution time.

4. Method according to Claim 3,
**characterized in that** the values of the variable parameters (AD, RRWL, RRBL, YS) are each transferred to the submethod (A1, A2) which follows the currently active submethod (A1, A2).

5. Method according to one of the preceding claims,
**characterized in that** the submethods (A1, A2) comprise the following steps:
- after the programming of a specific number of redundant lines (RWL, RBL), the programming of at least one of the redundant lines is cancelled in the event of a further defect being ascertained,
- and this redundant line (RWL, RBL) is programmed for the repair of a defect of another memory cell (MC).

6. Method according to Claim 5,
**characterized in that** a first submethod (A1) comprises the following steps:
- programmings of redundant lines (RWL, RBL) that have been performed in preceding submethods (A1, A2) are cancelled,
- the memory cells (MC) are tested for defects in a row by row manner, beginning with a start address,
- in the event of a defect of the currently tested memory cell (MC) being ascertained, the relevant column line (BL) is replaced by one of the redundant column lines (RBL), provided that the number (X) of programmed redundant column lines (RBL) does not exceed a limit value (Y) in the process,
- in the event of the limit value (Y) being exceeded, all programmings of redundant column lines (RBL) which have been effected on account of defects ascertained in the relevant row line (WL) are cancelled,
- and the relevant row line (WL) is replaced by one of the redundant row lines (RW1).

7. Method according to Claim 6,
**characterized in that** the first submethod (A1) is ended if all of the memory cells (MC) have been repaired or if, after the further defect has been ascertained, in the event of the limit value (Y) being exceeded, all of the redundant row lines (RWL) have already been programmed.

8. Method according to Claim 6,
**characterized in that** the limit value (Y) is altered during the execution time of the first submethod (A1).

9. Method according to Claim 5,
**characterized in that** a second submethod (A2) comprises the following steps:
- the memory cells (MC) are tested, beginning with a start address,
- after all of the redundant lines (RWL, RBL) have been programmed, the programming of one of the redundant lines is cancelled, in the event of a further defect being ascertained,
- the memory cells (MC) are subsequently tested anew, beginning with the start address,
- if, in the process, a defect is ascertained which is arranged before the further defect in address terms, the cancelling of the programming of the corresponding redundant line (RDL, RBL) is reversed,
- the three preceding method steps are subsequently repeated with regard to the cancelling of the programming of another of the redundant lines (RWL, RBL),
- if, after the cancelling of the programming of one of the redundant lines (RWL, RBL), no defect which is arranged before the further defect in address terms is ascertained during the subsequent testing of the memory cells (MC), said further defect is repaired using the redundant line which has become free due to the cancelling of its programming.

10. Method according to Claim 9,
**characterized in that** the second submethod (A2) is ended if all of the memory cells (MC) have been repaired or if, after the further defect has been ascertained, the successive cancelling of the programming of all of the redundant lines (RBL, RWL) does not enable all of the defects identified hitherto to be repaired.

## Revendications

1. Procédé de réparation de cellules (MC) de mémoire défaillantes dans une mémoire intégrée à semi-conducteur, qui sont raccordées à respectivement un conducteur (WL) de ligne et respectivement un conducteur (BL) de colonne, par une programmation réversible de conducteurs (RWL) redondants de ligne et de conducteurs (RBL) redondants de colonne ayant les caractéristiques suivantes :
- on utilise au moins deux procédés (A1, A2) partiels différents de réparation de cellules (MC) défaillantes de la mémoire qui se déroulent l'un après l'autre,
- dans les procédés (A1, A2) partiels, on vérifie les cellules (MC) de mémoire l'une après l'autre et respectivement après la constatation d'une défaillance de la cellule de mémoire vérifiée respectivement, on remplace, avant de vérifier une autre cellule de mémoire, le conducteur (WL) de ligne ou le conducteur (BL) de colonne auquel la cellule de mémoire est raccordée, pour lequel on a constaté la défaillance, par programmation de l'un des conducteurs (RWL, RBL) redondants,
- les procédés (A1, A2) partiels se distinguent par la succession de la vérification des cellules (MC) de mémoire et par celui des conducteurs (RWL, RBL) redondants qui a été programmé pour remplacer le conducteur (WL) de ligne concerné ou le conducteur (BL) de colonne concerné,
- on appelle un procédé (A1, A2) partiel avec une signature (R) de défaillance mettant fin au procédé partiel et contenant l'information sur le nombre des cellules (MC) de mémoire vérifiées et sur le nombre des lignes (RBL, RWL) redondantes programmées ou sur les lignes (RRBL, RRWL) redondantes restantes,
- ensuite, on appelle, en fonction de la signature (R) de défaillance du procédé (A1, A2) partiel précédent, un autre procédé (A1, A2) partiel qui, au début, ne fait pas cesser en tout ou partie la programmation effectuée.

2. Procédé suivant la revendication 1,
**caractérisé en ce que** l'on poursuit le procédé avec l'appel de l'un des procédés (A1, A2) partiels jusqu'à ce que toutes les cellules (MC) de mémoire aient été vérifiées et réparées ou jusqu'à ce que la mémoire soit considérée comme ne pouvant pas être réparée.

3. Procédé suivant l'une des revendications précédentes,
**caractérisé en ce que** la signature (R) de défaillance comprend un ou plusieurs paramètres (AD, RRWL, RRBL, YS) dont les valeurs peuvent être modifiées pendant la durée d'exécution.

4. Procédé suivant la revendication 3,
**caractérisé en ce que** l'on transmet les valeurs des paramètres (AD, RRWL, RRBL, YS) qui peuvent être modifiés respectivement aux procédés (A1, A2) partiels suivant le procédé (A1, A2) partiel qui vient juste d'être actif.

5. Procédé suivant l'une des revendications précédentes,
**caractérisé en ce que** les procédés (A1, A2) partiels comprennent les stades suivants :
- après avoir effectué une programmation d'un certain nombre de conducteurs (RWL, RBL) redondants, on met fin, si l'on constate une autre défaillance, à la programmation d'au moins l'un des conducteurs redondants,
- et l'on programme ce conducteur (RWL, RBL) redondant pour la réparation d'une défaillance d'une autre cellule (MC) de mémoire.

6. Procédé suivant la revendication 5,
**caractérisé en ce qu'**un premier procédé (A1) partiel comprend les stades suivants :
- on met fin à des programmations de conducteurs (RWL, RBL) redondants effectuées dans des procédés (A1, A2) partiels précédents,
- on vérifie ligne par ligne qu'il y a des défaillances dans les cellules (MC) de mémoire en commençant par une adresse de début,
- si l'on constate une défaillance de la cellule (MC) de mémoire qui vient d'être vérifiée, on remplace le conducteur (BL) de colonne concerné par l'un des conducteurs (RBL) de colonne redondants, pour autant que le nombre (X) des conducteurs (RBL) de colonne redondants programmés n'a pas dépassé une valeur (Y) limite,
- si la valeur (Y) limite est dépassée, on met fin à toutes les programmations de conducteurs (RBL) de colonne redondants qui se sont effectuées en raison de défaillances constatées dans le conducteur (WL) de ligne concerné,
- et l'on remplace le conducteur (WL) de ligne concerné par l'un des conducteurs (RWL) de lignes redondants.

7. Procédé suivant la revendication 6,
**caractérisé en ce que** l'on met fin au premier procédé (A1 ) partiel lorsque toutes les cellules (MC) de mémoire sont réparées ou lorsque, après avoir constaté la défaillance supplémentaire lorsque la valeur (Y) limite est dépassée, tous les conducteurs (RWL) de lignes redondants ont déjà été programmés.

8. Procédé suivant la revendication 6,
**caractérisé en ce que** l'on modifie la valeur (Y) limite pendant la durée d'exécution du premier procédé (A1) partiel.

9. Procédé suivant la revendication 5,
**caractérisé en ce qu'**un deuxième procédé (A2) partiel comprend les stades suivants :
- on vérifie les cellules (MC) de mémoire en commençant par une adresse de début,
- après que tous les conducteurs (RWL, RBL) redondants ont été programmés, on met fin, lorsque l'on constate une défaillance supplémentaire, à la programmation de l'un des conducteurs redondants,
- ensuite, on vérifie à nouveau les cellules (MC) de mémoire en commençant par l'adresse de début,
- pour autant que l'on a constaté une défaillance qui est disposée du point de vue de l'adresse avant la défaillance supplémentaire, on revient sur le fait d'avoir mis fin à la programmation du conducteur (RWL, RBL) redondant correspondant,
- ensuite, on répète les trois stades de procédé précédents en ce qui conceme le fait de mettre fin à la programmation d'un autre des conducteurs (RWL, RBL) redondants,
- dans la mesure où, après avoir mis fin à la programmation de l'un des conducteurs (RWL, RBL) redondants pendant la vérification venant ensuite des cellules (MC) de mémoire, on n'a pas constaté de défaillance qui est disposée du point de vue de l'adresse avant la défaillance supplémentaire, on répare celle-ci par le conducteur redondant devenu libre par le fait que l'on a mis fin à sa programmation.

10. Procédé suivant la revendication 9,
**caractérisé en ce que** l'on met fin au deuxième procédé (A2) partiel lorsque toutes les cellules (MC) de mémoire sont réparées ou lorsque, après constatation de la défaillance supplémentaire, la cessation à laquelle on procède successivement de la programmation de tous les conducteurs (RBL, RWL) redondants ne permet pas d'effectuer une réparation de toutes les défaillances détectées jusqu'ici.
